# EUROPÄISCHE PATENTSCHRIFT

(11) **EP 1 875 607 B1**
(45) Veröffentlichungstag und Bekanntmachung des Hinweises auf die Patenterteilung: **31.12.2008**
(21) Anmeldenummer: 06840936.6
(22) Anmeldetag: 11.11.2006
(51) Int. Cl.: H03H 7/01, H04B 1/10

(54) **EINGANGSFILTER ZUR SPIEGELFREQUENZUNTERDRÜCKUNG**
INPUT FILTER FOR IMAGE FREQUENCY SUPPRESSION
FILTRE D'ENTREE PERMETTANT LA SUPPRESSION DE LA FREQUENCE-IMAGE

(30) Priorität: 20.11.2005 DE 102005056486
(43) Veröffentlichungstag der Anmeldung: 09.01.2008
(73) Patentinhaber: ATMEL Germany GmbH, 74072 Heilbronn (DE)
(72) Erfinder: ALLES, Martin, 74182 Obersulm-Willsbach (DE)
(86) Internationale Anmeldenummer: PCT/EP2006/010831
(87) Internationale Veröffentlichungsnummer: WO 2007/057129

(56) Entgegenhaltungen:
- EP-A2- 1 311 063
- US-A- 4 956 710

## Beschreibung

Die Erfindung betrifft einen Eingangsfilter für einen Überlagerungsempfänger zur Spiegelfrequenzunterdrückung nach dem Oberbegriff des Anspruchs 1.

Überlagerungs- oder Superheterodyn-Empfänger dienen zum Empfangen hochfrequenter, drahtlos übertragener Signale. Derartige Empfänger werden beispielsweise in Radioempfängern und Mobiltelefonen verwendet. Im Gegensatz zum so genannten Geradeausempfänger wird beim Überlagerungsempfänger das Empfangssignal vor der Demodulation mit Hilfe eines so genannten Mischers auf eine oder mehrere Zwischenfrequenzen "gemischt" bzw. umgesetzt.

Im Mischer wird hierzu das Empfangssignal typischerweise mit einem sinusförmigen Oszillationssignal mit einstellbarer, von der gewünschten Empfangsfrequenz abhängigen Abstimmfrequenz multipliziert. Wenn die Frequenz des Empfangssignals fₑ und die Frequenz des Oszillationssignals bzw. die Abstimmfrequenz fₒ beträgt, weist ein Mischerausgangssignal Frequenz von fₒ+fₑ und fₒ-fₑ auf.

Das Mischerausgangssignal wird durch ein so genanntes Zwischenfrequenzfilter gefiltert. Das Zwischenfrequenzfilter ist üblicherweise als Bandpass ausgeführt, d.h. ein Frequenzband des Mischerausgangssignals im Bereich der Zwischenfrequenz f_{z} des Zwischenfrequenzfilters wird im wesentlichen ungedämpft durch das Zwischenfrequenzfilter übertragen. Spektrale Anteile des Mischerausgangssignal außerhalb des Frequenzbandes werden stark gedämpft bzw. im Idealfall nicht durch das Zwischenfrequenzfilter übertragen.

Durch das Zwischenfrequenzfilter werden folglich nur Empfangssignale übertragen, für deren Frequenz fₑ=fₒ+f_{z} oder fₑ=fₒ-f_{z} gilt. In anderen Worten werden nur die Empfangssignale, die um den Wert der Zwischenfrequenz f_{z} von der Abstimmfrequenz fₒ versetzt sind, durch den Zwischenfrequenzfilter übertragen.

Die Zwischenfrequenz f_{z} des Zwischenfrequenzfilters wird hierbei statisch vorgegeben, wodurch die Filtereigenschaften des Zwischenfrequenzfilters im Vergleich zu einem Fall verbessert werden können, bei dem die Frequenz dynamisch, in Abhängigkeit von der gewünschten Empfangsfrequenz eingestellt wird, da die Filtereigenschaften über den gesamten Empfangsfrequenzbereich hinweg konstant bleiben.

Wenn das Eingangssignal des Empfängers dem Mischer ungefiltert zugeführt wird, überlagern sich im Mischerausgangssignal Eingangssignale mit der Frequenz fₑ=fₒ+f_{z} und fₑ=fₒ-f_{z}, wodurch beispielsweise ungewollt zwei Radiosender gleichzeitig empfangen werden, wenn auf beiden Frequenzen gesendet wird. Wenn beispielsweise nur die Frequenz fₑ=fₒ-f_{z} am Ausgang des Mischer auftreten soll, muss das Eingangssignal durch einen Eingangsfilter, beispielsweise mit einer Bandpasscharakteristik, derart gefiltert werden, dass die gewünschte Frequenz fₑ=fₒ-f_{z} möglichst wenig und die Frequenz fₑ=fₒ+f_{z} möglichst stark gedämpft wird. Die zu unterdrückende Frequenz, hier fₑ=fₒ+f_{z}, wird als Spiegelfrequenz bezeichnet.

Wenn alternativ nur die Frequenz fₑ=fₒ+f_{z} am Ausgang des Mischer auftreten soll, muss das Eingangsfilter entsprechend zur Unterdrückung der Frequenz fₑ=fₒ-f_{z} dimensioniert werden. Die Spiegelfrequenz ist in diesem Fall fₑ=fₒ-f_{z}. Das Dohument EP-A-1 311 063 offerbart en Beispiel offerbart ein Beispiel eine solcher Eingangsfilter.

Da sich die Spiegelfrequenz in Abhängigkeit von der variablen, gewünschten Empfangsfrequenz verändert, sind zur Spiegelfrequenzunterdrückung so genannte mitlaufende Eingangsfilter bekannt, die ihre Filtercharakteristik, beispielsweise ihre Mittenfrequenz, in Abhängigkeit von der eingestellten bzw. gewünschten Empfangsfrequenz verändern. Auf diese Weise lassen sich die Filtereigenschaften im Vergleich zu statisch dimensionierten Filtern verbessern.

Es ist die Aufgabe der Erfindung, ein Eingangsfilter für einen Überlagerungsempfänger zur Verfügung zu stellen, welche die gewünschte Empfangsfrequenz möglichst wenig und die Spiegelfrequenz möglichst stark dämpfen.

Die Erfindung löst diese Aufgabe durch ein Eingangsfilter nach Anspruch 1.

Der erfindungsgemäße Eingangsfilter umfasst einen ersten Filterkreis mit Bandpasscharakteristik und einer in Abhängigkeit von einer gewünschten Empfangsfrequenz vorgebbaren Mittenfrequenz, der eine Kapazitätsdiode und eine erste Filterinduktivität umfasst, die parallel geschaltet sind und einen Parallelschwingkreis bilden, wobei die Mittenfrequenz durch Anlegen einer Steuerspannung an die Kapazitätsdiode vorgebbar ist. Das Eingangsfilter umfasst weiterhin einen zweiten Filterkreis mit Bandsperrencharakteristik, der die Kapazitätsdiode und eine zweite Filterinduktivität umfasst. Die Kapazitätsdiode und die zweite Filterinduktivität sind in Serie geschaltet und bilden einen Serienschwingkreis. Der zweite Filterkreis weist eine maximale Dämpfung im Bereich einer zu der gewünschten Empfangsfrequenz gehörenden Spiegelfrequenz auf. Der zweite Filterkreis ist derart dimensioniert, dass seine Impedanz im Bereich der Spiegelfrequenz möglichst kleine Werte aufweist. Dies bewirkt eine selektive, zusätzliche Dämpfung der Spiegelfrequenz, ohne dass eine zusätzliche Dämpfung der gewünschten Empfangsfrequenz verursacht wird. Bei einer Änderung der Empfangsfrequenz durch Anlegen der Steuerspannung an die Kapazitätsdiode, verändert sich sowohl die Mittenfrequenz des Parallelschwingkreises als auch der Frequenzbereich maximaler Dämpfung des Serienschwingkreises, da die Kapazitätsdiode bzw. Varaktordiode sowohl Teil des Parallelschwingkreises als auch des Serienschwingkreises ist. Auf diese Weise wird ohne zusätzlich steuernde Eingriffe ein automatisches Nachführen der Spiegelfrequenzunterdrückung bei einer Änderung der Empfangsfrequenz erzielt.

In einer Weiterbildung des Eingangsfilters ist die zweite Filterinduktivität zwischen einen Verbindungsknoten eines ersten Anschlusses der Kapazitätsdiode und eines ersten Anschlusses der ersten Filterinduktivität und ein Massepotential eingeschleift. Dies bewirkt eine optimale Kopplung der beiden Filterkreise.

In einer Weiterbildung des Eingangsfilters ist ein erster DC-Entkopplungskondensator vorgesehen, der zwischen den Verbindungsknoten des ersten Anschlusses der Kapazitätsdiode und des ersten Anschlusses der ersten Filterinduktivität und die zweite Filterinduktivität eingeschleift ist. Auf diese Weise wird die an die Kapazitätsdiode angelegte Steuerspannung gleichspannungsrnäßig bzw. DC-mäßig von der zweite Filterinduktivität entkoppelt bzw. getrennt.

In einer Weiterbildung des Eingangsfilters ist ein zweiter DC-Entkopplungskondensator vorgesehen, der zwischen einen zweiten Anschluss der Kapazitätsdiode und einen zweiten Anschluss der ersten Filterinduktivität eingeschleift ist. Dies verhindert, dass die an die Kapazitätsdiode angelegte Steuerspannung durch die erste Filterinduktivität kurzgeschlossen wird.

In einer Weiterbildung des Eingangsfilters ist ein Bezugspotentialverbindungswiderstand vorgesehen, der zwischen den zweiten Anschluss der Kapazitätsdiode und ein Massepotential eingeschleift ist. Dieser Bezugspotentialverbindungswiderstand dient zum Verbinden des zweiten Anschlusses, beispielsweise der Anode, der Kapazitätsdiode mit Bezugspotential, um in Verbindung mit der am ersten Anschluss der Kapazitätsdiode angelegten Steuerspannung eine Potentialdifferenz an der Kapazitätsdiode einzustellen, welche die wirksame Kapazität bestimmt. Hohe Frequenzen werden über den insbesondere hochohmigen Bezugspotentialverbindungswiderstand aufgrund der Fehlanpassung nicht übertragen.

In einer Weiterbildung des Eingangsfilters ist ein dritter DC-Entkopplungskondensator vorgesehen, der zwischen einen zweiten Anschluss der Kapazitätsdiode und einen Eingangsanschluss des Eingangsfilters eingeschleift ist. Dies dient der DC-Entkopplung des Eingangsanschlusses.

In einer Weiterbildung des Eingangsfilters ist ein Steuerspannungsverbindungswiderstand vorgesehen, der zwischen einen Verbindungsknoten eines ersten Anschlusses der Kapazitätsdiode und eines ersten Anschlusses der ersten Filterinduktivität und eine Steuerspannungsquelle eingeschleift ist. Dies dient zur HF-Entkopplung der Steuerspannungsquelle.

In einer Weiterbildung des Eingangsfilters ist ein vierter DC-Entkopplungskondensator vorgesehen, der zwischen einen zweiten Anschluss der ersten Filterinduktivität und einen Ausgangsanschluss des Eingangsfilters eingeschleift ist. Dies dient zur DC-Entkopplung des Ausgangsanschlusses.

Die Erfindung wird nachfolgen unter Bezugnahme auf die Zeichnungen beschrieben. Hierbei zeigen schematisch:
- Fig. 1: einen Überlagerungsempfänger in Form eines DAB-Empfängers mit einem erfindungsgemäßen Eingangsfilter und
- Fig. 2: eine Übertragungsfunktion des Eingangsfilters von Fig. 1.

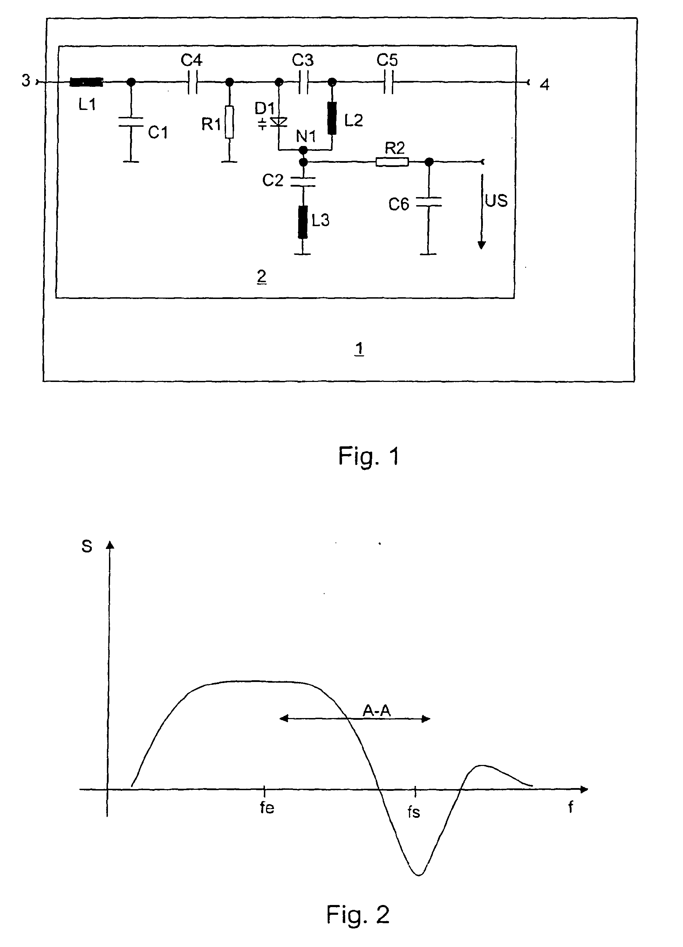

Fig. 1 zeigt einen Überlagerungsempfänger in Form eines DAB-Empfängers 1 mit einem erfindungsgemäßen Eingangsfilter 2.

Das Eingangsfilter 2 umfasst einen Eingangsanschluss 3, zum Anschluss einer nicht gezeigten Antenne, einen Ausgangsanschluss 4 zur Ausgabe eines gefilterten Eingangssignals, einen Eingangstiefpass in Form einer Induktivität bzw. Spule L1 und eines Kondensators C1, einen ersten Filterkreis in Form eines Parallelschwingkreises aus einer Kapazitätsdiode D1 und einer Filterinduktivität L2, einen zweiten Filterkreis in Form eines Serienschwingkreises aus der Kapazitätsdiode D1 und einer zweiten Filterinduktivität L3, einen ersten DC-Entkopplungskondensator C2, der zwischen einen Verbindungsknoten N1 eines ersten Anschlusses der Kapazitätsdiode D1 und eines ersten Anschlusses der ersten Filterinduktivität L2 und die zweite Filterinduktivität L3 eingeschleift ist, einen zweiten DC-Entkopplungskondensator C3, der zwischen einen zweiten Anschluss der Kapazitätsdiode D1 und einen zweiten Anschluss der ersten Filterinduktivität L2 eingeschleift ist, einen dritten DC-Entkopplungskondensator C4, der zwischen den zweiten Anschluss der Kapazitätsdiode und den Eingangsanschluss 3 des Eingangsfilters 2 eingeschleift ist, einen vierten DC-Entkopplungskondensator C5, der zwischen den zweiten Anschluss der ersten Filterinduktivität L2 und den Ausgangsanschluss 4 des Eingangsfilters 2 eingeschleift ist, einen Bezugspotentialverbindungswiderstand R1, der zwischen den zweiten Anschluss der Kapazitätsdiode D1 und ein Massepotential bzw. Erdpotential eingeschleift ist, einen Steuerspannungsverbindungswiderstand R2, der zwischen den Verbindungsknoten N1 des ersten Anschlusses der Kapazitätsdiode D1 und des ersten Anschlusses der ersten Filterinduktivität L2 und eine Steuerspannungsquelle US eingeschleift ist, und einen Filterkondensator C6.

Der Eingangsfilter 2 dient zur Spiegelfrequenzunterdrückung eines am Eingangsanschluss 3 anliegenden Empfangssignals und ist als mitlaufendes Filter ausgebildet, d.h. seine Filtercharakteristik, beispielsweise seine Mittenfrequenz und ein Bereich mit der größten Dämpfung, wird in Abhängigkeit von der eingestellten Empfangsfrequenz gewählt. Am Ausgangsanschluss 4 ist ein nicht gezeigter Verstärker und nachfolgend eine Mischer zum Umsetzen des gefilterten Signals am Ausgangsanschluss 4 auf eine Mischerfrequenz vorgesehen. Diese Einheiten entsprechen im wesentlichen denen eines herkömmlichen DAB-Empfängers und sind daher nicht näher beschrieben.

Der DC-Entkopplungskondensator C4 dient zur DC-Entkopplung des Eingangs 3 und der DC-Entkopplungskondensator C5 dient zur DC-Entkopplung des Ausgangs 5. Der DC-Entkopplungskondensator C3 verhindert, dass die Steuerspannung US gleichstrommäßig über die erste Filterinduktivität L2 und den Bezugspotentialverbindungswiderstand R1 nach Masse kurzgeschlossen wird. Für hohe Frequenzen wirkt der DC-Entkopplungskondensator C3 als Kurzschluss. Der DC-Entkopplungskondensator C2 verhindert, dass die Steuerspannung US gleichstrommäßig über die zweite Filterinduktivität L3 nach Masse kurz-geschlossen wird. Für hohe Frequenzen wirkt der DC-Entkopplungskondensator C2 als Kurzschluss.

Die an der Kapazitätsdiode D1 anstehende Steuerspannung US bestimmt deren wirksame Kapazität. Die Steuerspannung US wird derart gewählt bzw. erzeugt, dass der Parallelschwingkreis für eine gewünschte Empfangsfrequenz fₑ einen Sperrkreis bildet.

Der Bezugspotentialverbindungswiderstand R1 verbindet die Anode der Kapazitätsdiode D1 gleichstrommäßig mit Masse und stellt für hohe Frequenzen aufgrund einer Fehlanpassung einen Leerlauf dar. Der Steuerspannungsverbindungswiderstand R2 verbindet die Kathode der Kapazitätsdiode D1 gleichstrommäßig mit der Steuerspannung US und stellt für hohe Frequenzen aufgrund einer Fehlanpassung einen Leerlauf dar, d.h. entkoppelt die Steuerspannung US HF-technisch von den verbleibenden Schaltungsteilen. Der Kondensator C6 dient als Filter.

Der Eingangstiefpass aus der Induktivität L1 und dem Kondensator C1 dient zur Trennung bzw. Unterdrückung eines so genannten L-Bandes im Frequenzbereich von ca. 1452MHz bis 1492MHz. Die Übertragungsfunktion des Eingangstiefpasses wird derart dimensioniert, dass Eingangssignale in einem so genannten VHF-BIII-Band im Frequenzbereich von 174MHz bis 240MHz durchgelassen werden.

Der erste Filterkreis aus der Kapazitätsdiode D1 und der ersten Filterinduktivität L2 weist eine Bandpasscharakteristik auf, wobei eine Mittenfrequenz des Bandpasses durch Anlegen der Steuerspannung US an die Kapazitätsdiode D1 vorgebbar ist und die Steuerspannung US in Abhängigkeit von einer gewünschten Empfangsfrequenz fₑ eingestellt wird.

Der zweite Filterkreis aus der Kapazitätsdiode D1 und der zweiten Filterinduktivität L3 weist eine Bandsperrencharakteristik mit einer maximalen Dämpfung im Bereich einer zu der gewünschten Empfangsfrequenz fₑ gehörenden Spiegelfrequenz fₛ auf. Der Wert der Spiegelfrequenz fₛ ergibt sich anhand der gewählten Empfangsfrequenz fₑ bzw. einer Abstimmfrequenz eines nicht gezeigten, herkömmlichen Mischers und einer gewählten Zwischenfrequenz f_{z} des Überlagerungsempfängers 1.

Fig. 2 zeigt eine Übertragungsfunktion des Eingangsfilters 2 von Fig. 1. Aufgrund der Kombination der Bandpasscharakteristik des Parallelschwingkreises aus der Kapazitätsdiode D1 und der ersten Filterinduktivität L2 und der Bandsperrencharakteristik des Serienschwingkreises aus der Kapazitätsdiode D1 und der zweiten Filterinduktivität L3 kann das Eingangssignal das Eingangsfilter 2 im Frequenzbereich der eingestellten bzw. vorgegebenen Empfangsfrequenz fₑ praktisch ungedämpft passieren, wohingegen bei der Spiegelfrequenz fₛ eine hohe Dämpfung auftritt.

Da die Kapazitätsdiode D1 Teil beider Schwingkreise ist, führt eine Kapazitätsänderung der Kapazitätsdiode D1 sowohl zu einer Verschiebung der Mittenfrequenz des Parallelschwingkreises als auch zu einer Verschiebung der Frequenz mit maximaler Dämpfung des Serienschwingkreises. Die in Fig. 2 gezeigte Übertragungsfunktion wird folglich in Abhängigkeit von der gewählten Steuerspannung US in etwa entlang der Achse A-A in Y-Richtung verschoben.

Die gezeigte Ausführungsform des Eingangsfilters 2 weist eine Filtercharakteristik auf, bei der die gewünschte Empfangsfrequenz fₑ lediglich geringfügig bzw. nicht gedämpft und die Spiegelfrequenz fₛ stark bedämpft wird. Aufgrund der selektiven Erhöhung der Spielgelfrequenzdämfung durch den separaten Filterkreis, der durch Einfügen der zweiten Filterinduktivität L3 zwischen den Fußpunkt N1 des Parallelschwingkreises und Masse entsteht, kann das Eingangsfilter mit geringerer Selektivität ausgelegt werden. Insgesamt führt dies zu einer erhöhten Empfangsleistung des Empfängers 1.

Bei der gezeigten Ausführungsform wurde der Eingangsfilter 2 in dem DAB-Empfänger 1 eingesetzt. Es versteht sich, dass das Eingangsfilter 2 auch in anderen Empfängern, beispielsweise DVB-Empfängern oder herkömmlichen AM/FM-Radioempfängern verwendbar ist.

## Patentansprüche

1. Eingangsfilter für einen Überlagerungsempfänger (1) mit
- einem ersten Filterkreis mit Bandpasscharakteristik und einer in Abhängigkeit von einer gewünschten Empfangsfrequenz (fₑ) vorgebbaren Mittenfrequenz, der eine Kapazitätsdiode (D1) und eine erste Filterinduktivität (L2) umfasst, die parallel geschaltet sind und einen Parallelschwingkreis bilden, wobei die Mittenfrequenz durch Anlegen einer Steuerspannung (US) an die Kapazitätsdiode (D1) vorgebbar ist,
**gekennzeichnet durch**
- einen zweiten Filterkreis mit Bandsperrencharakteristik, der die Kapazitätsdiode (D1) und eine zweiten Filterinduktivität (L3) umfasst, die in Serie geschaltet sind und einen Serienschwingkreis bilden, und eine maximale Dämpfung im Bereich einer zu der gewünschten Empfangsfrequenz (fₑ) gehörenden Spiegelfrequenz (fₛ) aufweist.

2. Eingangsfilter nach Anspruch 1, **dadurch gekennzeichnet, dass** die zweite Filterinduktivität (L3) zwischen einen Verbindungsknoten (N1) eines ersten Anschlusses der Kapazitätsdiode (D1) und eines ersten Anschlusses der ersten Filterinduktivität (L2) und ein Massepotential eingeschleift ist.

3. Eingangsfilter nach Anspruch 2, **gekennzeichnet durch** einen ersten DC-Entkopplungskondensator (C2), der zwischen den Verbindungsknoten (N1) des ersten Anschlusses der Kapazitätsdiode (D1) und des ersten Anschlusses der ersten Filterinduktivität (L2) und die zweite Filterinduktivität (L3) eingeschleift ist.

4. Eingangsfilter nach einem der vorhergehenden Ansprüche, **gekennzeichnet durch** einen zweiten DC-Entkopplungskondensator (C3), der zwischen einen zweiten Anschluss der Kapazitätsdiode (D1) und einen zweiten Anschluss der ersten Filterinduktivität (L2) eingeschleift ist.

5. Eingangsfilter nach einem der vorhergehenden Ansprüche, **gekennzeichnet durch** einen Bezugspotentialverbindungswiderstand (R1), der zwischen den zweiten Anschluss der Kapazitätsdiode (D1) und ein Massepotential eingeschleift ist.

6. Eingangsfilter nach einem der vorhergehenden Ansprüche, **gekennzeichnet durch** einen dritten DC-Entkopplungskondensator (C4), der zwischen einen zweiten Anschluss der Kapazitätsdiode (D1) und einen Eingangsanschluss (3) des Eingangsfilters (2) eingeschleift ist.

7. Eingangsfilter nach einem der vorhergehenden Ansprüche, **gekennzeichnet durch** einen Steuerspannungsverbindungswiderstand (R2), der zwischen einen Verbindungsknoten (N1) eines ersten Anschlusses der Kapazitätsdiode (D1) und eines ersten Anschlusses der ersten Filterinduktivität (L2) und eine Steuerspannungsquelle (US) eingeschleift ist.

8. Eingangsfilter nach einem der vorhergehenden Ansprüche, **gekennzeichnet durch** einen vierten DC-Entkopplungskondensator (C5), der zwischen einen zweiten Anschluss der ersten Filterinduktivität und einen Ausgangsanschluss (4) des Eingangsfilters (2) eingeschleift ist.

## Claims

1. Input filter for a superheterodyne receiver (1) comprising
- a first filter circuit with band-pass characteristic and a centre frequency, which is predeterminable in dependence on a desired receiving frequency (fₑ) and which comprises a variable capacitance diode (D1) and a first filter inductance (L2), the diode and inductance being connected in parallel and forming a parallel oscillator circuit, wherein the centre frequency is predeterminable by application of a control voltage (US) to the variable capacitance diode (D1),
**characterised by**
- a second filter circuit with band-blocking characteristic, which comprises the variable capacitance diode (D1) and a second filter inductance (L3), which are connected in series and form a series oscillator circuit and which have a maximum attenuation in the region of an image frequency (fₛ) belonging to the desired receiving frequency (fₑ).

2. Input filter according to claim 1, **characterised in that** the second filter inductance (L3) is connected between a connecting junction (N1) of a first connection of the variable capacitance diode (D1) and a first connection of the first filter inductance (L2) and a ground potential.

3. Input filter according to claim 2, **characterised by** a first DC-decoupling capacitor (C2) which is connected between the connecting junction (N1) of the first connection of the variable capacitance diode (D1) and the first connection of the first filter inductance (L2) and the second filter inductance (L3).

4. Input filter according to any one of the preceding claims, **characterised by** a second DC-decoupling capacitor (C3) which is connected between a second connection of the variable capacitance diode (D1) and a second connection of the first filter inductance (L2).

5. Input filter according to any one of the preceding claims, **characterised by** a reference potential connecting resistor (R1) which is connected between the second connection of the variable capacitance diode (D1) and a ground potential.

6. Input filter according to any one of the preceding claims, **characterised by** a third DC decoupling capacitor (C4) which is connected between a second connection of the variable capacitance diode (D1) and an input connection (3) of the input filter (2).

7. Input filter according to any one of the preceding claims, **characterised by** a control voltage connecting resistor (R2) which is connected between a connecting junction (N1) of a first connection of the variable capacitance diode (D1) and a first connection of the first filter inductance (L2) and a control voltage source (US).

8. Input filter according to any one of the preceding claims, **characterised by** a fourth DC decoupling capacitor (C5) which is connected between a second connection of the first filter inductance and an output connection (4) of the input filter (2).

## Revendications

1. Filtre d'entrée pour un récepteur superhétérodyne (1) comprenant
• un premier circuit de filtrage passe-bande et fréquence médiane prédéterminée en fonction d'une fréquence souhaitée de réception (fₑ), comprenant une diode à capacité variable (D1) et une première inductance de filtrage (L2), montées en parallèle et formant un circuit oscillant parallèle, la fréquence médiane étant prédéterminée par l'application d'une tension de commande (US) à la diode à capacité (D1),
**caractérisé par** :
• un deuxième circuit de filtrage passe-bande, comprenant la diode à capacité variable (D1) et une deuxième inductance de filtrage (L3), montées en série et formant un circuit oscillant série, et présentant une atténuation maximale dans la zone d'une fréquence image (fₛ) appartenant à la fréquence souhaitée de réception (fₑ).

2. Filtre d'entrée selon la revendication 1, **caractérisé en ce que** la deuxième inductance de filtrage (L3) est insérée entre un noeud de connexion (N1) d'une première électrode de la diode à capacité (D1) et d'une première connexion de la première inductance de filtrage (L2), et un potentiel de masse.

3. Filtre d'entrée selon la revendication 2, **caractérisé par** un premier condensateur de découplage en courant continu (C2), inséré entre le noeud de connexion (N1) de la première électrode de la diode à capacité variable (D1) et de la première connexion de la première inductance de filtrage (L2), et la deuxième inductance de filtrage (L3).

4. Filtre d'entrée selon l'une quelconque des revendications précédentes, **caractérisé par** un deuxième condensateur de découplage en courant continu (C3) inséré entre une deuxième électrode de la diode à capacité variable (D1) et une deuxième connexion de la première inductance de filtrage (L2).

5. Filtre d'entrée selon l'une quelconque des revendications précédentes, **caractérisé par** une résistance de liaison (R1) au potentiel de référence, inséré entre la deuxième électrode de la diode à capacité (D1) et un potentiel de masse.

6. Filtre d'entrée selon l'une quelconque des revendications précédentes, **caractérisé par** un troisième condensateur de découplage en courant continu (C4), inséré entre une deuxième électrode de la diode à capacité (D1) et une connexion d'entrée (3) du filtre d'entrée (2).

7. Filtre d'entrée selon l'une quelconque des revendications précédentes, **caractérisé par** une résistance de liaison (R2) à la tension de commande, insérée entre un noeud de connexion (N1) d'une première électrode de la diode à capacité variable (D1) et d'une première connexion de la première inductance de filtrage (L2), et une source de tension de commande (US).

8. Filtre d'entrée selon l'une quelconque des revendications précédentes, **caractérisé par** un quatrième condensateur de découplage en courant continu (C5) inséré entre une deuxième connexion de la première inductance de filtrage et une connexion de sortie (4) du filtre d'entrée (2).
